(19) Europäisches Patentamt / European Patent Office / Office européen des brevets

(11) EP 1 956 665 A1

(12) **EUROPEAN PATENT APPLICATION**
published in accordance with Art. 158(3) EPC

(43) Date of publication:
**13.08.2008 Bulletin 2008/33**

(21) Application number: **06833267.5**

(22) Date of filing: **24.11.2006**

(51) Int Cl.:
***H01L 51/50*** *(2006.01)* ***C09K 11/06*** *(2006.01)*

(86) International application number:
**PCT/JP2006/323463**

(87) International publication number:
**WO 2007/061063 (31.05.2007 Gazette 2007/22)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **28.11.2005 JP 2005341989**

(71) Applicant: **Idemitsu Kosan Co., Ltd.**
**Chiyoda-ku**
**Tokyo 100-8321 (JP)**

(72) Inventors:
- **ARAKANE, Takashi**
  **Sodegaura-shi**
  **Chiba 299-0293 (JP)**
- **KUMA, Hitoshi**
  **Sodegaura-shi**
  **Chiba 299-0293 (JP)**
- **FUKUOKA, Kenichi**
  **iSodegaura-shi**
  **Chiba 299-0293 (JP)**
- **YAMAMOTO, Hiroshi**
  **Sodegaura-shi**
  **Chiba 299-0293 (JP)**
- **HOSOKAWA, Chishio**
  **Sodegaura-shi**
  **Chiba 299-0293 (JP)**

(74) Representative: **Gille Hrabal Struck Neidlein Prop Roos**
**Patentanwälte**
**Brucknerstrasse 20**
**40593 Düsseldorf (DE)**

(54) **ORGANIC ELECTROLUMINESCENT DEVICE**

(57) An organic electroluminescent device including, a hole-transporting layer, an emitting layer and an electron-transporting layer in this order between an anode and a cathode, an emission spectrum having emission peaks when applying current for emission, the intensity ($I_D$) of the maximum emission peak among the emission peaks and the intensity ($I_O$) of another emission peak at a shorter wavelength than the wavelength of the maximum emission peak among the emission peaks satisfying the following formula (A),

$$I_O / I_D < 1/50 \quad \cdots (A).$$

FIG.1

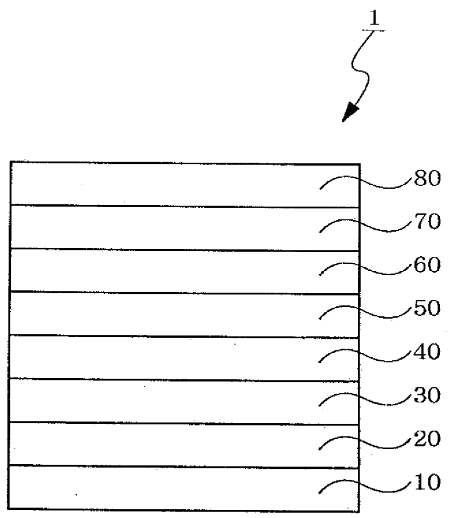


EP 1 956 665 A1

## Description

Technical Field

The invention relates to an organic electroluminescent device. In detail, it relates to an organic electroluminescent device having a long life time and a high luminous efficiency, and emitting red light.

Technical Background

An organic EL device is a self-emission device by the use of the principle that a fluorescent compound emits light by the recombination energy of holes injected from an anode and electrons injected from a cathode when an electric field is impressed.

Since C. W. Tang et al. of Eastman Kodak Co. reported a low-voltage driven organic EL device in the form of a stacked type device (C. W. Tang, S. A. Vanslyke, Applied Physics Letters, Vol. 51, p.913, 1987, and the like), studies on organic EL devices wherein organic materials are used as the constitution materials has actively conducted.

Tang et al. uses tris(8-hydroxyquinolinol) aluminum for an emitting layer and a triphenyldiamine derivative for a hole-transporting layer in the stacked structure. The advantages of the stacked structure are to increase injection efficiency of holes to the emitting layer, to increase generation efficiency of excitons generated by recombination while blocking electrons injected from the cathode, to contain the excitons generated in the emitting layer, and so on. Like this example, as the device structure of the organic EL device, a two-layered type of a hole-transporting (injecting) layer and an electron-transporting emitting layer, and a three-layered type of a hole-transporting (injecting) layer, an emitting layer and an electron-transporting (injecting) layer are widely known. In such stacked structure devices, the device structures and the fabrication methods have been contrived to increase recombination efficiency of injected holes and electrons.

Patent document 1 discloses a device wherein a dicyanoanthracene derivative and an indenoperylene derivative are used in an emitting layer, and a metal complex is used in an electron-transporting layer. However, the emission color thereof is not pure red, and is reddish orange because the CIE chromaticity is (0.63, 0.37).

Holes are injected through the emitting layer into the electron-transporting layer to recombine with electrons in the electron-transporting layer. The metal complex of the electron-transporting layer then emits slightly to degrade the chromaticity. Further, the electron-transporting layer having a low hole resistance deteriorates so that the lifetime is remarkably shorten.

Patent document 2 discloses a red device wherein a naphthacene derivative and an indenoperylene derivative are used in an emitting layer, and a naphthacene derivative is used in an electron-transporting layer. The device has a high color purity and a practical life time. However, the device requires two organic layers (electron-transporting layer and electron-injecting layer) which have separated functions and are arranged between an anode and a cathode. The structure of the device is complicated.

Patent document 3 proposes an emission-preventing layer which has a greater band gap than those of an emitting layer and an electron-transporting layer for suppressing emission of the electron-transporting layer. However, the luminous efficiency of the emitting device is as insufficient as about 1 cd/A.

[Patent document 1] JP-A-2001-307885
[Patent document 2] JP-A-2003-338377
[Patent document 3] JP-A-2005-235564

An object of the invention is to provide an organic EL device having a high color purity and practical lifetime.

Though research for solving the foregoing subjects, the inventors found that, in a device where holes injected from an anode reach the interface between an emitting layer and an electron-transporting layer, light emitted from a layer other than an emitting layer (dopant), particularly an electron-transporting layer, is weaken to a sufficiently low level compared to light emitted from the dopant, the injection of holes into an electron-transporting layer can be suppressed, thereby significantly enhancing the lifetime and luminous efficiency. The inventors made the invention based on the finding.

The invention provides the following organic EL device.

1. An organic electroluminescent device comprising,
a hole-transporting layer, an emitting layer and an electron-transporting layer in this order between an anode and a cathode,
an emission spectrum having emission peaks when applying current for emission,
the intensity ($I_D$) of the maximum emission peak among the emission peaks and the intensity ($I_O$) of another emission peak at a shorter wavelength than the wavelength of the maximum emission peak among the emission peaks

satisfying the following formula (A),

$$I_O / I_D < 1/50 \quad \cdots (A).$$

2. The organic electroluminescent device according to 1, wherein the maximum emission peak intensity ($I_D$) and the other emission peak intensity ($I_O$) satisfy the following formula (B),

$$I_O / I_D < 1/100 \quad \cdots (B).$$

3. The organic electroluminescent device according to 1, wherein the maximum emission peak intensity ($I_D$) and the other emission peak intensity ($I_O$) satisfy the following formula (C),

$$I_O / I_D < 1/500 \quad \cdots (C).$$

4. The organic electroluminescent device according to any one of 1 to 3, wherein a difference in ionization potential ($\Delta$Ip) between the hole-transporting layer and the emitting layer is 0.25 eV or less.
5. The organic electroluminescent device according to any one of 1 to 4, wherein the other emission peak derives from emission of the electron-transporting layer.
6. The organic electroluminescent device according to any one of 1 to 5, wherein the emitting layer contains an indenoperylene derivative represented by the following formula (1),

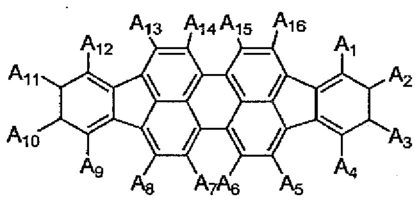

wherein $A_1$ to $A_{16}$ are each a hydrogen atom, halogen atom, alkyl group, alkoxy group, alkylthio group, alkenyl group, alkenyloxy group, alkenylthio group, aromatic-ring-containing alkyl group, aromatic-ring-containing alkyloxy group, aromatic-ring-containing alkylthio group, aromatic ring group, aromatic ring oxy group, aromatic ring thio group, aromatic ring alkenyl group, alkenyl aromatic ring group, amino group, cyano group, hydroxyl group, $-COOR^1$ ($R^1$ is a hydrogen atom, alkyl group, alkenyl group, aromatic-ring-containing alkyl group, or aromatic ring group), $-COR^2$ ($R^2$ is a hydrogen atom, alkyl group, alkenyl group, aromatic-ring-containing alkyl group, aromatic ring group or amino group) or $-OCOR^3$ ($R^3$ is an alkyl group, alkenyl group, aromatic-ring-containing alkyl group or aromatic ring group); and adjacent groups of $A_1$ to $A_{16}$ may be bonded to each other to form a ring with a substituted carbon atom.
7. The organic electroluminescent device according to 6, wherein the indenoperylene derivative is a dibenzotetraphenylperiflanthene derivative.
8. The organic electroluminescent device according to any one of 1 to 6, wherein the emitting layer contains a compound represented by the following formula (2),

$$X\text{-}(Y)_n \qquad (2)$$

wherein X is a condensed aromatic ring group with two or more carbocycles, Y is a group selected from substituted or unsubstituted aryl, substituted or unsubstituted diarylamino, substituted or unsubstituted arylalkyl and substituted or unsubstituted alkyl groups, and n is an integer of 1 to 6, provided that Ys may be the same or different when n is 2 or more.
9. The organic electroluminescent device according to 8, wherein X, in the formula (2), contains at least one skeleton

selected from naphthacene, pyrene, benzoanthracene, pentacene, dibenzoanthracene, benzopyrene, benzofluorene, fluoranthene, benzofluoranthene, naphthylfluoranthene, dibenzofluorene, dibenzopyrene, dibenzofluoranthene and acenaphtylfluoranthene.

10. The organic electroluminescent device according to 8, wherein the compound of the formula (2) is one or more types of compounds selected from a naphthacene derivative, a diaminoanthracene derivative, a naphthofluoranthene derivative, a diaminopyrene derivative, a diaminoperylene derivative, an aminoanthracene derivative, an aminopyrene derivative or a dibenzochrysene derivative.

11. The electroluminescent device according to any one of 1 to 10, wherein the electron-transporting layer contains a compound represented by the following formula (3),

A-B (3)

wherein A is an aromatic hydrocarbon group with three or more carbocycles and B is a substituted or unsubstituted heterocyclic group.

12. The organic electroluminescent device according to 11, wherein the compound represented by the formula (3) is a compound containing in the molecule thereof at least one skeleton selected from anthracene, phenanthrene, naphthacene, pyrene, chrysene, benzoanthracene, pentacene, dibenzoanthracene, benzopyrene, fluorene, benzofluorene, fluoranthene, benzofluoranthene, naphthofluoranthene, dibenzofluorene, dibenzopyrene and dibenzofluoranthene.

13. The organic electroluminescent device according to 11, wherein the compound represented by the formula (3) is a nitrogen-containing heterocyclic compound.

14. The organic electroluminescent device according to 13, wherein the nitrogen-containing heterocyclic compound is a nitrogen-containing heterocyclic compound containing in the molecule thereof at least one skeleton selected from pyridine, pyrimidine, pyrazine, pyridazine, triazine, quinoline, quinoxaline, acridine, imidazopyridine, imidazopyrimidine and phenenthroline.

15. The organic electroluminescent device according to 13, wherein the nitrogen-containing heterocyclic compound is a benzoimidazole derivative represented by the following formula (4) or (5),

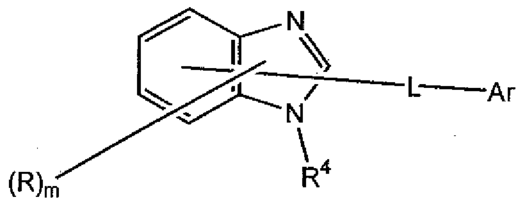

(4)

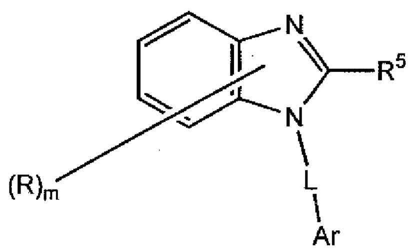

(5)

wherein R is a hydrogen atom, a $C_{6-60}$ aryl group which may have a substituent, a pyridyl group which may have a substituent, a quinolyl group which may have a substituent, a $C_{1-20}$ alkyl group which may have a substituent, or a $C_{1-20}$ alkoxy group which may have a substituent;

m is an integer of 0 to 4;

$R^4$ is a $C_{6-60}$ aryl group which may have a substituent, a pyridyl group which may have a substituent, a quinolyl group which may have a substituent, a $C_{1-20}$ alkyl group which may have a substituent, or a $C_{1-20}$ alkoxy group which may have a substituent;

$R^5$ is a hydrogen atom, a $C_{6-60}$ aryl group which may have a substituent, a pyridyl group which may have a substituent, a quinolyl group which may have a substituent, a $C_{1-20}$ alkyl group which may have a substituent, or a $C_{1-20}$ alkoxy group;

L is a $C_{6-60}$ arylene group which may have a substituent, a pyridinylene group which may have a substituent, a quinolinylene group which may have a substituent, or a fluorenylene group which may have a substituent; and Ar is a $C_{6-60}$ aryl group which may have a substituent, a pyridinyl group which may have a substituent, or a quinolyl group which may have a substituent.

The invention provides an organic EL device excellent in color purity with a long lifetime.

Brief Description of Drawings

FIG. 1 is a diagram showing one embodiment of an organic EL device of the invention.

BEST MODE FOR CARRYING OUT THE INVENTION

The organic EL device of the invention includes at least a hole-transporting layer, emitting layer and electron-transporting layer between an anode and a cathode.
Fig.1 is a sectional view showing one example of an organic EL device according to the invention.
An organic EL device 1 has a structure in which an anode 20, hole-injecting layer 30, hole-transporting layer 40, emitting layer 50, electron-transporting layer 60, electron-injecting layer 70 and cathode 80 are stacked on a substrate 10 in this order. The organic EL device may have various other structures.
The device of the invention has an emission spectrum having emission peaks at the time of emitting light at a current density of any of 0.1 to 1000 mA/cm$^2$ and, among the emission peaks, the intensity ($I_D$) of the maximum emission peak and the intensity ($I_O$) of another emission peak at a shorter wavelength than the wavelength of the maximum emission peak satisfy the following formula (A),

$$I_O / I_D < 1/50 \quad \cdots (A).$$

By satisfying this requirement, the device having a high luminous efficiency and long lifetime can be obtained. Preferred is $I_o/I_D/1/100$ (formula (B)), and particularly preferred $I_o/I_D/1/500$ (formula (c)).
The emission peak is determined by the following procedures. First, an organic EL device obtained is driven by a DC constant current with a current density of at least one value in the range from 0.1 to 1000 mA/cm$^2$ for emission. The spectrum of the emission is measured with a spectral radiant luminance meter at wavelengths from 380 to 780 nm at 1 nm intervals.
For the spectrum measured, $I_D$ is taken to represent the intensity of a peak having the maximum emission intensity and $I_O$ is taken to represent the intensity of another peak at a wavelength shorter than that of the maximum emission peak.
The other emission peak is preferably derived from the emission of an electron-transporting layer. The reduction of the emission from an electron-transporting layer improves, especially, the lifetime of a device.
The constitution of the organic EL device according to the invention is effective for devices where holes present which reach an electron-transporting layer through an emitting layer. For example, in EL devices where the difference ($\Delta I_P$) in ionization potential between a hole-transporting layer and an emitting layer is 0.25 eV or less, holes reach an electron-transporting layer.
The method for measuring ionization potential will be described in Examples stated later.
The organic EL device of the invention can be fabricated by selecting materials for a hole-transporting layer, an emitting layer and an electron-transporting layer so as to satisfy the above conditions.

[Emitting layer]

An emitting layer of an organic EL device possesses the following functions:

(i) an injection function; which enables to inject holes from an anode or hole-injecting, transporting layer and inject electrons from a cathode or electron-injecting, transporting layer, when an electric field is impressed,
(ii) a transport function; which transports injected electric charge (electrons and holes) with an electric field's power, and
(iii) an emitting function; which provides a recombination site for electrons and holes to emit light.

There may be a difference in ease of injection between holes and electrons, and also a difference in transport capacity that is represented by mobilities of holes and electrons. However, moving one of the electric charges is preferred.

As methods of forming this emitting layer, known methods such as vacuum deposition, spin coating and LB technique can be applied.

An emitting layer is particularly preferably a molecule-deposited film.

The term "molecule-deposited film" here means a thin film that is formed by depositing a material compound in a vapor phase and a film formed by solidifying a material compound in a solution state or liquid state. Usually this molecule-deposited film can be distinguished from a thin film formed by the LB technique (a molecule-accumulated film) by differences in agglutination structure and higher dimension structure, and functional differences caused thereby.

As disclosed in JP-A-57-51781, an emitting layer can also be formed by dissolving a binder such as resins and material compound in a solvent to make a solution and forming a thin film therefrom by spin coating and so on.

An emitting layer is mainly made of a host material and a dopant material. The doping concentration of the dopant in the emitting layer is preferably 0.1 to 10%, more preferably 0.5 to 2%. Therefore, the ionization potential of the emitting layer means that of the host material in the invention.

The indenoperylene derivative represented by following formula (1) is preferably used as the dopant material of the invention.

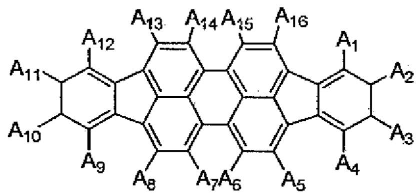

wherein $A_1$ to $A_{16}$ are each a hydrogen atom, halogen atom, alkyl group, alkoxy group, alkylthio group, alkenyl group, alkenyloxy group, alkenylthio group, aromatic-ring-containing alkyl group, aromatic-ring-containing alkyloxy group, aromatic-ring-containing alkylthio group, aromatic ring group, aromatic ring oxy group, aromatic ring thio group, aromatic ring alkenyl group, alkenyl aromatic ring group, amino group, cyano group, hydroxyl group, $-COOR^1$ ($R^1$ is a hydrogen atom, alkyl group, alkenyl group, aromatic-ring-containing alkyl group, or aromatic ring group), $-COR^2$ ($R^2$ is a hydrogen atom, alkyl group, alkenyl group, aromatic-ring-containing alkyl group, aromatic ring group or amino group) or $-OCOR^3$ ($R^3$ is an alkyl group, alkenyl group, aromatic-ring-containing alkyl group or aromatic ring group); and adjacent groups of $A_1$ to $A_{16}$ may be bonded to each other to form a ring with a substituted carbon atom.

The indenoperylene derivative is particularly preferably a dibenzotetraphenylperiflanthene derivative.

A compound represented by following formula (2) is preferably used as the host material of the invention,

$$X\text{-}(Y)_n \qquad (2)$$

wherein X is a condensed aromatic ring group with two or more carbocycles, Y is a group selected from substituted or unsubstituted aryl, substituted or unsubstituted diarylamino, substituted or unsubstituted arylalkyl and substituted or unsubstituted alkyl groups, and n is an integer of 1 to 6, provided that Ys may be the same or different when n is 2 or more.

In the formula (2), X is preferably a group containing at least one skeleton selected from naphthacene, pyrene, anthracene, perylene, chrysene, benzoanthracene, pentacene, dibenzoanthracene, benzopyrene, benzofluorene, fluoranthene, benzofluoranthene, naphthylfluoranthene, dibenzofluorene, dibenzopyrene, dibenzofluoranthene and acenaphtylfluoranthene; and more preferably a group containing a naphthacene skeleton or anthracene skeleton.

Y is preferably an aryl group or a diarylamino group with 12 to 60 carbon atoms, more preferably an aryl group with 12 to 20 carbon atoms or a diarylamino group with 12 to 40 carbon atoms. n is preferably 2.

Specific examples of the compound represented by formula (2) include one or more kinds of compounds selected from naphthacene derivatives, diaminoanthracene derivatives, naphthofluoranthene derivatives, diaminopyrene derivatives, diaminoperylene derivatives, dibenzidine derivatives aminoanthracene derivatives, aminopyrene derivatives and dibenzochrysene derivatives.

[Electron-transporting layer]

A compound represented by following formula (3) is preferably used as a material for forming an electron-transporting layer,

A-B (3)

wherein A is an aromatic hydrocarbon residue with 3 or more carboncircles and B is a substituted or unsubstituted heterocyclic group.

The compound represented by formula (3) preferably contains one or more kinds of heterocyclic compounds containing in the molecule thereof at least one skeleton selected from anthracene, phenanthrene, naphthacene, pyrene, chrysene, benzoanthracene, pentacene, dibenzoanthracene, benzopyrene, fluorene, benzofluorene, fluoranthene, benzofluoranthene, naphthofluoranthene, dibenzofluorene, dibenzopyrene and dibenzofluoranthene; and is more preferably a nitrogen-containing heterocyclic compound.

The nitrogen-containing heterocyclic compound more preferably contains one or more kinds of nitrogen-containing heterocyclic compounds containing in the molecule thereof at least one skeleton selected from pyridine, pyrimidine, pyrazine, pyridazine, triazine, quinoline, quinoxaline, acridine, imidazopyridine, imidazopyrimidine and phenenthroline. As a nitrogen-containing heterocyclic compound, a benzoimidazole derivative represented by formula (4) or (5) is exemplified,

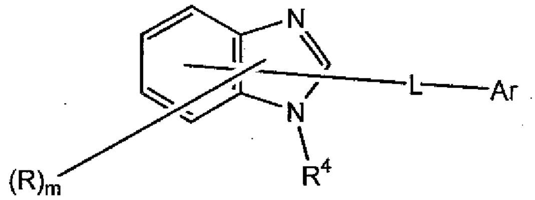

(4)

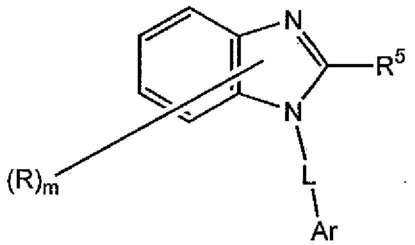

(5)

wherein R is a hydrogen atom, a $C_{6-60}$ aryl group which may have a substituent, a pyridyl group which may have a substituent, a quinolyl group which may have a substituent, a $C_{1-20}$ alkyl group which may have a substituent, or a $C_{1-20}$ alkoxy group which may have a substituent;
m is an integer of 0 to 4;
$R^4$ is a $C_{6-60}$ aryl group which may have a substituent, a pyridyl group which may have a substituent, a quinolyl group which may have a substituent, a $C_{1-20}$ alkyl group which may have a substituent, or a $C_{1-20}$ alkoxy group which may have a substituent;
$R^5$ is a hydrogen atom, a $C_{6-60}$ aryl group which may have a substituent, a pyridyl group which may have a substituent, a quinolyl group which may have a substituent, a $C_{1-20}$ alkyl group which may have a substituent, or a $C_{1-20}$ alkoxy group which may have a substituent;
L is a $C_{6-60}$ arylene group which may have a substituent, a pyridinylene group which may have a substituent, a quinolinylene group which may have a substituent, or a fluorenylene group which may have a substituent; and
Ar is a $C_{6-60}$ aryl group which may have a substituent, a pyridinyl group which may have a substituent, or a quinolyl group which may have a substituent.

For the benzoimidazole derivatives represented by formulas (4) and (5), m is preferably 0, $R^4$ and $R^5$ are preferably an aryl group, L is preferably an arylene group with 6 to 30 carbon atoms (more preferably 6 to 20 carbon atoms) and Ar is preferably an aryl group with 6 to 30 carbon atoms.

The organic EL device of the invention can have a known structure so long as the above-mentioned hole-transporting layer, emitting layer and electron-transporting layer are selected so as to satisfy the above conditions. Explanation will be given below.

[Structure of organic EL device]

The typical examples of the structure of the organic EL device of the invention are shown below. The invention is not limited to these.

(1) Anode/hole-transporting layer/emitting layer/electron-transporting layer/cathode
(2) Anode/hole-injecting layer/hole-transporting layer/emitting layer/electron-transporting layer/cathode
(3) Anode/hole-transporting layer/emitting layer/electron-transporting layer/electron-injecting layer/cathode
(4) Anode/hole-injecting layer/hole-transporting layer/emitting layer/electron-transporting layer/electron-injecting layer/cathode
(5) Anode/insulative layer/hole-transporting layer/emitting layer/electron-transporting layer/cathode
(6) Anode/hole-transporting layer/emitting layer/electron-transporting layer/insulative layer/cathode
(7) Anode/insulative layer/hole-transporting layer/emitting layer/electron-transporting layer/insulative layer/cathode
(8) Anode/hole-injecting layer/hole-transporting layer/emitting layer/electron-transporting layer/insulative layer/cathode
(9) Anode/insulative layer/hole-injecting layer/hole-transporting layer/emitting layer/electron-transporting layer/electron-injecting layer/cathode
(10)Anode/insulative layer/hole-injecting layer/hole-transporting layer/emitting layer/electron-transporting layer/electron-injecting layer/insulative layer/cathode

Among these, the structures (1), (2), (3), (4), (7), (8) and (10) are generally preferably used.
An electron-transporting layer and electron-injecting layer may be separately formed as the above structures (3), (4), (9) and (10) in the invention. However, the structure wherein an electron-transporting layer only is formed as the other structures also has a greater lifetime than a conventional device.

[Transparent substrate]

The organic EL device of the invention is formed on a substrate. When outcoupling light through a substrate, a transparent substrate is used. The transparent substrate is a substrate for supporting the organic EL device, and is preferably a flat and smooth substrate having a transmittance of 50% or more to light rays within visible ranges of 400 to 700 nm.
Specific examples thereof include glass plates and polymer plates. Examples of the glass plate include soda-lime glass, barium/strontium-containing glass, lead glass, aluminosilicate glass, borosilicate glass, barium borosilicate glass, and quartz. Examples of the polymer plate include polycarbonate, acrylic polymer, polyethylene terephthalate, polyethersulfide, and polysulfone.

[Anode]

The anode of the organic thin film EL device plays a role for injecting holes into its hole-transporting layer or emitting layer. The anode effectively has a work function of 4.5 eV or more. Specific examples of the material of the anode used in the invention include indium tin oxide alloy (ITO), zinc tin oxide alloy (IZO), tin oxide (NESA), gold, silver, platinum, and copper.
Although these materials may be used individually, alloys thereof or materials wherein another element is added to the materials can be selected for use.
The anode can be formed by forming these electrode materials into a thin film by vapor deposition, sputtering or the like. In the invention, in the case where emission from the emitting layer is taken out through the anode, the transmittance of the anode to the emission is preferably more than 10%. The sheet resistance of the anode is preferably several hundreds Ω/□ or less. The film thickness of the anode, which is varied depending upon the material thereof, is usually from 10 nm to 1 μm, preferably from 10 to 200 nm.

[Hole-injecting, transporting layer]

The hole-injecting, transporting layer is a layer for helping the injection of holes into the emitting layer so as to transport the holes to a light emitting region. The hole mobility thereof is large and the ionization energy thereof is usually as small as 5.5 eV or less. Such a hole-injecting, transporting layer is preferably made of a material which can transport holes to the emitting layer at a lower electric field intensity. The hole mobility thereof is preferably at least $10^{-4}$ $cm^2/V \cdot$second when an electric field of, e.g., $10^4$ to $10^6$ V/cm is applied.
The material for forming the hole-transporting layer is not particularly limited so long as the material has the above-mentioned preferred natures. The material can be arbitrarily selected from materials which have been widely used as a hole-transporting material in photoconductive materials and known materials used in a hole-injecting layer of organic EL devices.

Specific examples thereof include triazole derivatives (see USP No. 3,112,197 and others), oxadiazole derivatives (see USP No. 3,189,447 and others), imidazole derivatives (see JP-B-37-16096 and others), polyarylalkane derivatives (see USP Nos. 3,615,402, 3,820,989 and 3,542,544, JP-B-45-555 and 51-10983, JP-A-51-93224, 55-17105, 56-4148, 55-108667, 55-156953 and 56-36656, and others), pyrazoline derivatives and pyrazolone derivatives (see USP Nos. 3,180,729 and 4,278,746, JP-A-55-88064, 55-88065, 49-105537, 55-51086, 56-80051, 56-88141, 57-45545, 54-112637 and 55-74546, and others), phenylene diamine derivatives (see USP No. 3,615,404, JP-B-51-10105, 46-3712 and 47-25336, JP-A-54-53435, 54-110536 and 54-119925, and others), arylamine derivatives (see USP Nos. 3,567,450, 3,180,703, 3,240,597, 3,658,520, 4,232,103, 4,175,961 and 4,012,376, JP-B-49-35702 and 39-27577, JP-A-55-144250, 56-119132 and 56-22437, DE1,110,518, and others), amino-substituted chalcone derivatives (see USP No. 3,526,501, and others), oxazole derivatives (ones disclosed in USP No. 3,257,203, and others), styrylanthracene derivatives (see JP-A-56-46234, and others), fluorenone derivatives (JP-A-54-110837, and others), hydrazone derivatives (see USP No. 3,717,462, JP-A-54-59143, 55-52063, 55-52064, 55-46760, 55-85495, 57-11350, 57-148749 and 2-311591, and others), stilbene derivatives (see JP-A-61-210363, 61-228451, 61-14642, 61-72255, 62-47646, 62-36674, 62-10652, 62-30255, 60-93455, 60-94462, 60-174749 and 60-175052, and others), silazane derivatives (USP No. 4,950,950), polysilanes (JP-A-2-204996), aniline copolymers (JP-A-2-282263), and electroconductive macromolecular oligomers (in particular thiophene oligomers) disclosed in JP-A-1-211399.

It is preferred to use a material represented by the following formula (6):

$$Q1\text{-}G\text{-}Q2 \qquad (6)$$

wherein Q1 and Q2 are residues having at least one tertiary amine, and G is a linking group.

It is more preferred to use an amine derivative represented by the following formula (7):

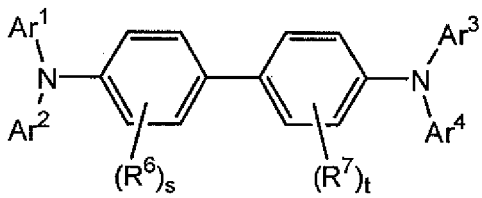

(7)

wherein $Ar^1$ to $Ar^4$ are independently a substituted or unsubstituted aromatic ring with 6 to 50 nucleus carbon atoms, or a substituted or unsubstituted hetero aromatic ring with 5 to 50 nucleus atoms; $R^6$ and $R^7$ are a substituent; s and t are independently an integer of 0 to 4; $Ar^1$ and $Ar^2$, and $Ar^3$ and $Ar^4$ may be linked to each other to form a ring structure; and $R^6$ and $R^7$ may also be linked to each other to form a ring structure.

The substituents of $Ar^1$ to $Ar^4$, $R^6$ and $R^7$ include substituted or unsubstituted aromatic rings with 6 to 50 nucleus carbon atoms; substituted or unsubstituted hetero aromatic rings with 5 to 50 nucleus atoms; alkyl groups with 1 to 50 carbon atoms; alkoxy groups with 1 to 50 carbon atoms; alkylaryl groups with 1 to 50 carbon atoms; aralkyl groups with 1 to 50 carbon atoms; a styryl group; amino groups substituted with aromatic rings with 6 to 50 nucleus carbon atoms or hetero aromatic rings with 5 to 50 nucleus atoms; or aromatic rings with 6 to 50 nucleus carbon atoms or hetero aromatic rings with 5 to 50 nucleus atoms substituted with amino groups substituted with aromatic rings with 6 to 50 nucleus carbon atoms or hetero aromatic rings with 5 to 50 nucleus atoms.

Further, a hole-injecting layer can be provided in addition to the hole-transporting layer so as to help the injection of holes. The material of the hole-injecting layer can be used as the material of the hole-transporting layer. The following are preferably used: porphyrin compounds (disclosed in JP-A-63-2956965 and others), aromatic tertiary amine compounds and styrylamine compounds (see USP No. 4,127,412, JP-A-53-27033, 54-58445, 54-149634, 54-64299, 55-79450, 55-144250, 56-119132, 61-295558, 61-98353 and 63-295695, and others), in particular, the aromatic tertiary amine compounds.

The following can also be given as examples: 4,4'-bis(N-(1-naphthyl)-N-phenylamino)biphenyl (hereinafter abbreviated to NPD), which has in the molecule thereof two condensed aromatic rings, disclosed in USP No. 5,061,569, and 4,4',4"-tris(N-(3-methylphenyl)-N-phenylamino)triphenylamine (hereinafter abbreviated to MTDATA), wherein three triphenylamine units are linked to each other in a star-burst form, disclosed in JP-A-4-308688.
The materials represented by the formula (6) and (7) are particularly preferred.

Inorganic compounds such as aromatic dimethylidine type compounds, p-type Si and p-type SiC can also be used as the material of the hole-injecting layer.

The hole-injecting, transporting layer can be formed by making the above-mentioned compound(s) into a thin film by a known method, such as vacuum deposition, spin coating, casting or LB technique. The film thickness of the hole-injecting, transporting layer is not particularly limited, and is usually from 5 nm to 5 μm. This hole-injecting, transporting layer may be a single layer made of one or more out of the above-mentioned materials. This hole-injecting, transporting layer may be stacked layers of the above-mentioned hole-injecting, transporting layer and another hole injecting, transporting layer made of a different material.

The organic semiconductive layer is also a type of the hole-transporting layer. The organic semiconductive layer is a layer for helping the injection of holes or electrons into the emitting layer, and is preferably a layer having an electroconductivity of $10^{-10}$ S/cm or more. The material of such an organic semiconductive layer may be an electroconductive oligomer, such as thiophene-containing oligomer or arylamine-containing oligomer disclosed in JP-A-8-193191, an electroconductive dendrimer such as arylamine-containing dendrimer.

[Electron-injecting layer]

The electron-injecting layer is a layer for helping the injection of electrons into the emitting layer, and has a large electron mobility. The adhesion improving layer is a layer made of a material particularly good in adhesion to the cathode among such electron-injecting layers.

A preferred embodiment of the invention is a device containing a reducing dopant in an interfacial region between its electron transferring region or cathode and its organic layer. The reducing dopant is defined as a substance which can reduce an electron transferring compound. Accordingly, various substances which have given reducing properties can be used. For example, at least one substance can be preferably used which is selected from the group consisting of alkali metals, alkaline earth metals, rare earth metals, alkali metal oxides, alkali metal halides, alkaline earth metal oxides, alkaline earth metal halides, rare earth metal oxides, rare earth metal halides, alkali metal organic complexes, alkaline earth metal organic complexes, and rare earth metal organic complexes.

More specific examples of the preferred reducing dopants include at least one alkali metal selected from the group consisting of Na (work function: 2.36 eV), K (work function: 2.28 eV), Rb (work function: 2.16 eV) and Cs (work function: 1.95 eV), and at least one alkaline earth metal selected from the group consisting of Ca (work function: 2.9 eV), Sr (work function: 2.0 to 2.5 eV), and Ba (work function: 2.52 eV). Metals having a work function of 2.9 eV or less are in particular preferred. Among these, a more preferable reducing dopant is at least one alkali metal selected from the group consisting of K, Rb and Cs. Even more preferable is Rb or Cs. Most preferable is Cs. These alkali metals are particularly high in reducing ability. Thus, the addition of a relatively small amount thereof to an electron injecting zone makes it possible to improve the luminance of the organic EL device and make the life time thereof long. As the reducing dopant having a work function of 2.9 eV or less, any combination of two or more out of these alkali metals is also preferred. Particularly preferred is any combination containing Cs, for example, combinations of Cs and Na, Cs and K, Cs and Rb, or Cs, Na and K. The combination containing Cs makes it possible to exhibit the reducing ability efficiently. The luminance of the organic EL device can be improved and the life time thereof can be made long by the addition thereof to its electron-injecting zone.

In the invention, an electron-injecting layer made of an insulator or a semiconductor may further be provided between a cathode and an organic layer. By providing the layer, current leakage can be effectively prevented to improve the injection of electrons. As the insulator, at least one metal compound selected from the group consisting of alkali metal calcogenides, alkaline earth metal calcogenides, halides of alkali metals and halides of alkaline earth metals can be preferably used. When the electron-injecting layer is formed of the alkali metal calcogenide or the like, the injection of electrons can be further improved, it being preferably. Specifically preferable alkali metal calcogenides include $Li_2O$, LiO, $Na_2S$, $Na_2Se$ and NaO and preferable alkaline earth metal calcogenides include CaO, BaO, SrO, BeO, BaS and CaSe. Preferable halides of alkali metals include LiF, NaF, KF, LiCl, KCl and NaCl. Preferable halides of alkaline earth metals include fluorides such as $CaF_2$, $BaF_2$, $SrF_2$, $MgF_2$ and $BeF_2$ and halides other than fluorides.

Examples of the semiconductor for forming an electron-transporting layer include oxides, nitrides or oxynitrides containing at least one element selected from Ba, Ca, Sr, Yb, Al, Ga, In, Li, Na, Cd, Mg, Si, Ta, Sb and Zn, and combinations of two or more thereof. The inorganic compound for an electron-injecting layer is preferably a microcrystalline or amorphous insulating thin film. When an electron-transporting layer is formed of the insulating thin film, a more uniform thin film can be formed to reduce pixel defects such as dark spots. Examples of such an inorganic compound include the above-mentioned alkali metal calcogenides, alkaline earth metal calcogenides, halides of alkali metals, and halides of alkaline earth metals.

[Cathode]

For the cathode, the following may be used: an electrode substance made of a metal, an alloy or an electroconductive compound, or a mixture thereof which has a small work function (4 eV or less). Specific examples of the electrode substance include sodium, sodium-potassium alloy, magnesium, lithium, magnesium/silver alloy, aluminum/aluminum oxide, aluminum/lithium alloy, indium, and rare earth metals.

This cathode can be formed by making the electrode substance(s) into a thin film by vapor deposition, sputtering or some other method.

In the case where emission from the emitting layer is taken out through the cathode, it is preferred to make the transmittance of the cathode to the emission larger than 10%.

The sheet resistance of the cathode is preferably several hundreds Ω/□ or less, and the film thickness thereof is usually from 10 nm to 1 μm, preferably from 50 to 200 nm.

[Insulative layer]

In the organic EL device, pixel defects based on leakage or a short circuit are easily generated since an electric field is applied to the super thin film. In order to prevent this, it is preferred to insert an insulator thin layer between the pair of electrodes.

Examples of the material used in the insulative layer include aluminum oxide, lithium fluoride, lithium oxide, cesium fluoride, cesium oxide, magnesium oxide, magnesium fluoride, calcium oxide, calcium fluoride, cesium fluoride, cesium carbonate, aluminum nitride, titanium oxide, silicon oxide, germanium oxide, silicon nitride, boron nitride, molybdenum oxide, ruthenium oxide, and vanadium oxide.

In the invention, a mixture or laminate thereof may be used.

[Examples of fabricating an organic EL device]

The organic EL device can be fabricated by forming an anode, a hole-transporting layer, an emitting layer and an electro-transporting layer, optionally forming a hole-injecting layer and an electron-injecting layer if necessary, and further forming a cathode by use of the materials and methods exemplified above. The organic EL device can be fabricated in the order reverse to the above, i.e., the order from a cathode to an anode.

An example of the fabrication of the organic EL device will be described below which has a structure wherein the following are successively formed over a transparent substrate: anode/hole-transporting layer/emitting layer/electron-transporting layer/cathode.

First, a thin film made of an anode material is formed into a thickness of 1 μm or less, preferably 10 to 200 nm on an appropriate transparent substrate by vapor deposition, sputtering or some other method, thereby forming an anode.

Next, a hole-transporting layer is formed on this anode. As described above, the hole-transporting layer can be formed by vacuum deposition, spin coating, casting, LB technique, or some other method. Vacuum deposition is preferred since a homogenous film is easily obtained and pinholes are not easily generated. In the case where the hole-transporting layer is formed by vacuum deposition, conditions for the deposition are varied depending upon the compound used (the material for the hole-transporting layer), the desired crystal structure or recombining structure of the hole-transporting layer, and others. In general, the conditions are appropriately selected from the following: deposition source temperatures of 50 to 450°C, vacuum degrees of $10^{-7}$ to $10^{-3}$ torr, vapor deposition rates of 0.01 to 50 nm/second, substrate temperatures of -50 to 300°C, and film thicknesses of 5 nm to 5 μm.

Next, an emitting layer is disposed on the hole-transporting layer. The emitting layer can also be formed by using a desired organic luminescent material and making the material into a thin film by vacuum deposition, sputtering, spin coating, casting or some other method. Vacuum deposition is preferred since a homogenous film is easily obtained and pinholes are not easily generated. In the case where the emitting layer is formed by vacuum deposition, conditions for the deposition, which are varied depending on the compound used, can be generally selected from conditions similar to those for the hole-transporting layer.

Next, an electron-transporting layer is formed on this emitting layer. Like the hole-transporting layer and the emitting layer, the layer is preferably formed by vacuum deposition in order to obtain a homogenous film.

Conditions for the deposition can be selected from conditions similar to those for the hole-transporting layer and the emitting layer.

Lastly, a cathode is stacked thereon to obtain an organic EL device.

The cathode is made of a metal, and vapor deposition or sputtering may be used. However, vacuum deposition is preferred in order to protect underlying organic layers from being damaged when the cathode film is formed.

For the organic EL device fabrication that has been described above, it is preferred that the formation from the anode to the cathode is continuously carried out, using only one vacuuming operation.

The method for forming each of the layers in the organic EL device of the invention is not particularly limited. A known forming method, such as vacuum deposition, molecular beam deposition, spin coating, dipping, casting, bar coating or roll coating can be used.

The film thickness of each of the organic layers in the organic EL device of the invention is not particularly limited. In general, defects such as pinholes are easily generated when the film thickness is too small. Conversely, a high applied voltage becomes necessary to make the efficiency bad when the film thickness is too large. Usually, therefore, the film thickness is preferably in the range of several nanometers to one micrometer.

## Examples

### Example 1

A transparent electrode made of an indium tin oxide with a thickness of 120 nm was provided on a grass substrate measuring 25 mm by 75 mm by 0.7 mm. The grass substrate was subjected to ultrasonic cleaning with isopropyl alcohol for 5 minutes, and cleaned with ultraviolet ozone for 30 minutes. The resultant substrate was mounted in a vacuum deposition device.

N',N''-bis[4-(diphenylamino)phenyl]-N',N''-diphenylbiphenyl-4,4'-diamine was deposited to form a 60 nm thick film as an hole-injecting layer on the substrate. Thereafter N,N'-bis[4'-{N-(naphthyl-1-yl)-N-phenyl} aminobiphenyl-4-yl]-N-phenylamine was deposited to form a 10 nm thick film as a hole-transporting layer thereon.
The ionization potential of the hole-transporting layer was 5.5 eV.

The ionization potential was measured by a cyclic voltammetry or a photoerectoron spectroscopy. The host material of the emitting layer was measured in the same way.

Next, the compound (A-1) of a naphthacene derivative shown below and the compound (B) of an indenoperylene derivative shown below were co-deposited such that the weight ratio of A-1 to B was 40 to 0.4, to form a 40 nm thick film as an emitting layer.

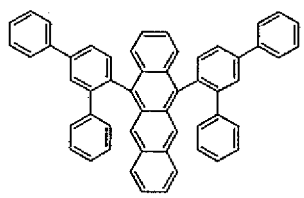

(A-1)

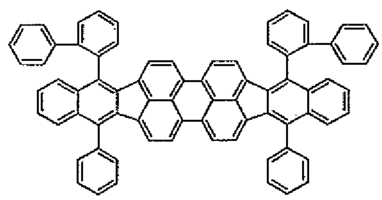

(B)

Ionization potential : 5.5 eV

Next, the compound (C-1) shown below was deposited to form a 30 nm thick film as an electron-transporting layer.

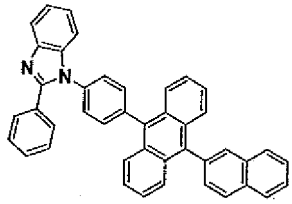

(C-1)

Next, lithium fluoride was deposited to form a 0.3 nm thick film, then aluminum was deposited to form a 150 nm thick film. This aluminum/lithium fluoride functioned as a cathode. An organic EL device was thus fabricated.
For the organic EL device thus obtained, a conduction test was performed. Red emission with a driving voltage of 4.1 V and emission luminance of 1135 $cd/m^2$ was obtained at a current density of 10 $mA/cm^2$. The chromaticity was (0.67, 0.33) and the efficiency was 11.35 cd/A. At this time, the peak intensity derived from a material other than the dopant

was 1/522 of that derived from the dopant. A direct current continuous applying test was conducted at an initial luminance of 5000 cd/m$^2$, and a period of time until the luminance reached 80% of the initial luminance was 2041 hours.
The emission spectrums of the devices fabricated in Example 1, and the following Examples and Comparative examples were measured with a spectral radiance luminance meter. The maximum peak wavelength, second maximum peak wavelength on the short wavelength side and relative intensity were shown in Table 1.
Table 2 shows the materials used, ratio of $I_o$ to $I_D$ ($I_O/I_D$), etc. and the evaluation results of the devices.
Table 1

| | Maximum peak | | 2nd peak on the short wavelength side | |
|---|---|---|---|---|
| | Position (nm) | Intensity: (relative intensity) | Position (nm) | Intensity: (relative intensity) |
| Example 1 | 611 | 1 | 522 | 0.001915 |
| Example 2 | 611 | 1 | 526 | 0.01692 |
| Comparative example 1 | 611 | 1 | 523 | 0.04468 |
| Example 3 | 610 | 1 | 532 | 0.005449 |
| Comparative example 2 | 611 | 1 | 533 | 0.05017 |
| Comparative example 3 | 611 | 1 | 530 | 0.1173 |

Table 2

| | Host material | Material of electron-transporting layer | ΔIp* (eV) | $I_O/I_D$ | Driving voltage (V) | Luminous efficiency (cd/A) | Chromaticity (X,Y) | 80% lifetime (h) |
|---|---|---|---|---|---|---|---|---|
| Example 1 | A-1 | C-1 | 0 | 1/522 | 4.1 | 11.35 | (0.67,0.33) | 2041 |
| Example 2 | A-1 | C-2 | 0 | 1/59 | 4.5 | 7.16 | (0.65,0.33) | 1190 |
| Comparative example 1 | A-1 | $Alq_3$ | 0 | 1/22 | 4.9 | 7.03 | (0.65,0.35) | 360 |
| Example 3 | A-3 | C-1 | 0 | 1/184 | 4.1 | 9.78 | (0.67,0.33) | 1544 |
| Comparative example 2 | A-3 | $Alq_3$ | 0 | 1/20 | 5.3 | 6.22 | (0.65,0.35) | 310 |
| Comparative example 3 | $Alq_3$ | $Alq_3$ | 0.2 | 1/9 | 9.4 | 1.40 | (0.58,0.38) | 20 |

$I_O/I_D$: Ratio of $I_O$ to $I_D$ wherein $I_D$ is the maximum emission peak intensity and
$I_o$ is another emission peak intensity at a shorter wavelength than that of the maximum emission peak
Ip: Ionization potential
*ΔIp: ΔIp between a hole-transporting layer and an emitting layer

Example 2

An organic EL device was fabricated in the same way as in Example 1 except that the compound (C-2) was used instead of the compound (C-1) when the electron-transporting layer was formed.

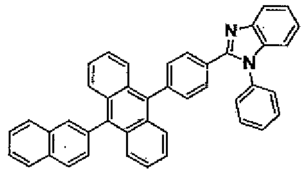

(C-2)

For the organic EL device thus obtained, a conduction test was performed. Red emission with a driving voltage of 4.5 V and emission luminance of 716 cd/$m^2$ was obtained at a current density of 10 mA/$cm^2$. The chromaticity was (0.65, 0.33) and the efficiency was 7.16 cd/A. At this time, the peak intensity derived from a material other than the dopant was 1/59 of that derived from the dopant. A direct current continuous applying test was conducted at an initial luminance of 5000 cd/$m^2$, and a period of time until the luminance reached 80% of the initial luminance was 1190 hours.

Comparative example 1

An organic EL device was fabricated in the same way as in Example 1 except that tris(8-hydroxy quinolinato) aluminum (hereinafter $Alq_3$) was used instead of the compound (C-1) when the electron-transporting layer was formed.

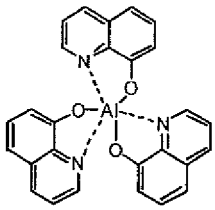

$Alq_3$

Ionization potential : 5.7 eV

For the organic EL device thus obtained, a conduction test was performed. Red emission with a driving voltage of 4.9 V and emission luminance of 703 cd/$m^2$ was obtained at a current density of 10 mA/$cm^2$. The chromaticity was (0.65, 0.35) and the efficiency was 7.03 cd/A. At this time, the peak intensity derived from a material other than the dopant was 1/22 of that derived from the dopant. A direct current continuous applying test was conducted at an initial luminance of 5000 cd/$m^2$, and a period of time until the luminance reached 80% of the initial luminance was 360 hours.

Example 3

An organic EL device was fabricated in the same way as in Example 1 except that the compound (A-3) below of a diaminoanthracene derivative was used instead of the compound (A-1) when the emitting layer was formed.

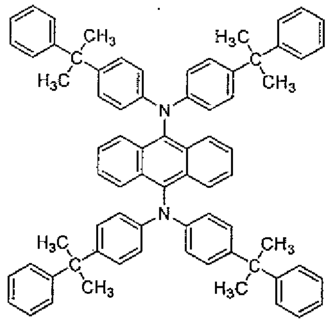

(A-3)

Ionization potential: 5.5 eV

For the organic EL device thus obtained, a conduction test was performed. Red emission with a driving voltage of 4.1 V and emission luminance of 978 cd/m$^2$ was obtained at a current density of 10 mA/cm$^2$. The chromaticity was (0.67, 0.33) and the efficiency was 9.78 cd/A. At this time, the peak intensity derived from a material other than the dopant was 1/184 of that derived from the dopant. A direct current continuous applying test was conducted at an initial luminance of 5000 cd/m$^2$, and a period of time until the luminance reached 80% of the initial luminance was 1544 hours.

Comparative example 2

An organic EL device was fabricated in the same way as in Example 3 except that $Alq_3$ was used instead of the compound (C-1) when the electron-transporting layer was formed.
For the organic EL device thus obtained, a conduction test was performed. Red emission with a driving voltage of 5.3 V and emission luminance of 622 cd/m$^2$ was obtained at a current density of 10 mA/cm$^2$. The chromaticity was (0.65, 0.35) and the efficiency was 6.22 cd/A. At this time, the peak intensity derived from a material other than the dopant was 1/20 of that derived from the dopant. A direct current continuous applying test was conducted at an initial luminance of 5000 cd/m$^2$, and a period of time until the luminance reached 80% of the initial luminance was 310 hours.

Comparative example 3

An organic EL device was fabricated in the same way as in Comparative example 1 except that $Alq_3$ was used instead of the compound (A-1) when the emitting layer was formed.
For the organic EL device thus obtained, a conduction test was performed. Red emission with a driving voltage of 9.4 V and emission luminance of 140 cd/m$^2$ was obtained at a current density of 10 mA/cm$^2$. The chromaticity was (0.58, 0.38) and the efficiency was 1.40 cd/A. At this time, the peak intensity derived from a material other than the dopant was 1/9 of that derived from the dopant. A direct current continuous applying test was conducted at an initial luminance of 5000 cd/m$^2$, and a period of time until the luminance reached 80% of the initial luminance was 20 hours.

Industrial Applicability

The organic EL device of the invention can be applied to the categories of various displays, displays, back light, light source, indicators, signboards, Interiors and the like, and particularly to display device of color displays.

## Claims

**1.** An organic electroluminescent device comprising,
a hole-transporting layer, an emitting layer and an electron-transporting layer in this order between an anode and a cathode,
an emission spectrum having emission peaks when applying current for emission,
the intensity ($I_D$) of the maximum emission peak among the emission peaks and the intensity ($I_o$) of another emission peak at a shorter wavelength than the wavelength of the maximum emission peak among the emission peaks satisfying the following formula (A),

$$I_O / I_D < 1/50 \quad \cdots (A).$$

**2.** The organic electroluminescent device according to claim 1, wherein the maximum emission peak intensity ($I_D$) and the other emission peak intensity ($I_o$) satisfy the following formula (B),

$$I_O / I_D < 1/100 \quad \cdots (B).$$

**3.** The organic electroluminescent device according to claim 1, wherein the maximum emission peak intensity ($I_D$) and the other emission peak intensity ($I_o$) satisfy the following formula (C),

$$I_O / I_D < 1/500 \quad \cdots (C).$$

**4.** The organic electroluminescent device according to any one of claims 1 to 3, wherein a difference in ionization potential (ΔIp) between the hole-transporting layer and the emitting layer is 0.25 eV or less.

**5.** The organic electroluminescent device according to any one of claims 1 to 4, wherein the other emission peak derives from emission of the electron-transporting layer.

**6.** The organic electroluminescent device according to any one of claims 1 to 5, wherein the emitting layer contains an indenoperylene derivative represented by the following formula (1),

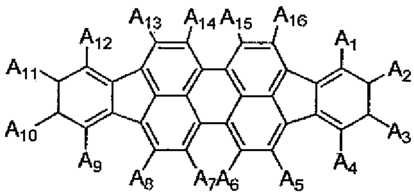

wherein $A_1$ to $A_{16}$ are each a hydrogen atom, halogen atom, alkyl group, alkoxy group, alkylthio group, alkenyl group, alkenyloxy group, alkenylthio group, aromatic-ring-containing alkyl group, aromatic-ring-containing alkyloxy group, aromatic-ring-containing alkylthio group, aromatic ring group, aromatic ring oxy group, aromatic ring thio group, aromatic ring alkenyl group, alkenyl aromatic ring group, amino group, cyano group, hydroxyl group, $-COOR^1$ ($R^1$ is a hydrogen atom, alkyl group, alkenyl group, aromatic-ring-containing alkyl group, or aromatic ring group), $-COR^2$ ($R^2$ is a hydrogen atom, alkyl group, alkenyl group, aromatic-ring-containing alkyl group, aromatic ring group or amino group) or $-OCOR^3$ ($R^3$ is an alkyl group, alkenyl group, aromatic-ring-containing alkyl group or aromatic ring group); and adjacent groups of $A_1$ to $A_{16}$ may be bonded to each other to form a ring with a substituted carbon atom.

**7.** The organic electroluminescent device according to claim 6, wherein the indenoperylene derivative is a dibenzotetraphenylperiflanthene derivative.

**8.** The organic electroluminescent device according to any one of claims 1 to 6, wherein the emitting layer contains a compound represented by the following formula (2),

$$X\text{-}(Y)_n \qquad (2)$$

wherein X is a condensed aromatic ring group with two or more carbocycles, Y is a group selected from substituted or unsubstituted aryl, substituted or unsubstituted diarylamino, substituted or unsubstituted arylalkyl and substituted

or unsubstituted alkyl groups, and n is an integer of 1 to 6, provided that Ys may be the same or different when n is 2 or more.

**9.** The organic electroluminescent device according to claim 8, wherein X, in the formula (2), contains at least one skeleton selected from naphthacene, pyrene, benzoanthracene, pentacene, dibenzoanthracene, benzopyrene, benzofluorene, fluoranthene, benzofluoranthene, naphthylfluoranthene, dibenzofluorene, dibenzopyrene, dibenzofluoranthene and acenaphtylfluoranthene.

**10.** The organic electroluminescent device according to claim 8, wherein the compound of the formula (2) is one or more types of compounds selected from a naphthacene derivative, a diaminoanthracene derivative, a naphthofluoranthene derivative, a diaminopyrene derivative, a diaminoperylene derivative, an aminoanthracene derivative, an aminopyrene derivative or a dibenzochrysene derivative.

**11.** The electroluminescent device according to any one of claims 1 to 10, wherein the electron-transporting layer contains a compound represented by the following formula (3),

A-B (3)

wherein A is an aromatic hydrocarbon group with three or more carbocycles and B is a substituted or unsubstituted heterocyclic group.

**12.** The organic electroluminescent device according to claim 11, wherein the compound represented by the formula (3) is a compound containing in the molecule thereof at least one skeleton selected from anthracene, phenanthrene, naphthacene, pyrene, chrysene, benzoanthracene, pentacene, dibenzoanthracene, benzopyrene, fluorene, benzofluorene, fluoranthene, benzofluoranthene, naphthofluoranthene, dibenzofluorene, dibenzopyrene and dibenzofluoranthene.

**13.** The organic electroluminescent device according to claim 11, wherein the compound represented by the formula (3) is a nitrogen-containing heterocyclic compound.

**14.** The organic electroluminescent device according to claim 13, wherein the nitrogen-containing heterocyclic compound is a nitrogen-containing heterocyclic compound containing in the molecule thereof at least one skeleton selected from pyridine, pyrimidine, pyrazine, pyridazine, triazine, quinoline, quinoxaline, acridine, imidazopyridine, imidazopyrimidine and phenenthroline.

**15.** The organic electroluminescent device according to claim 13, wherein the nitrogen-containing heterocyclic compound is a benzoimidazole derivative represented by the following formula (4) or (5),

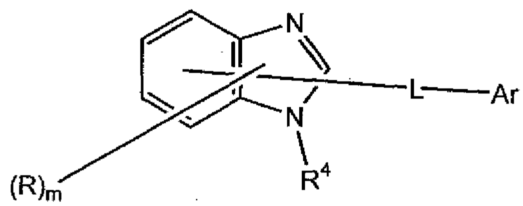

(4)

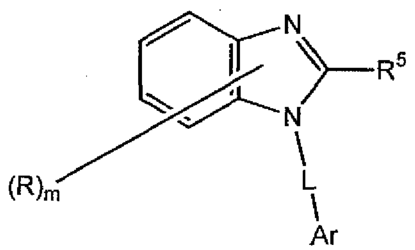

(5)

wherein R is a hydrogen atom, a $C_{6-60}$ aryl group which may have a substituent, a pyridyl group which may

have a substituent, a quinolyl group which may have a substituent, a $C_{1-20}$ alkyl group which may have a substituent, or a $C_{1-20}$ alkoxy group which may have a substituent;
m is an integer of 0 to 4;
$R^4$ is a $C_{6-60}$ aryl group which may have a substituent, a pyridyl group which may have a substituent, a quinolyl group which may have a substituent, a $C_{1-20}$ alkyl group which may have a substituent, or a $C_{1-20}$ alkoxy group which may have a substituent;
$R^5$ is a hydrogen atom, a $C_{6-60}$ aryl group which may have a substituent, a pyridyl group which may have a substituent, a quinolyl group which may have a substituent, a $C_{1-20}$ alkyl group which may have a substituent, or a $C_{1-20}$ alkoxy group;
L is a $C_{6-60}$ arylene group which may have a substituent, a pyridinylene group which may have a substituent, a quinolinylene group which may have a substituent, or a fluorenylene group which may have a substituent; and
Ar is a $C_{6-60}$ aryl group which may have a substituent, a pyridinyl group which may have a substituent, or a quinolyl group which may have a substituent.

FIG.1

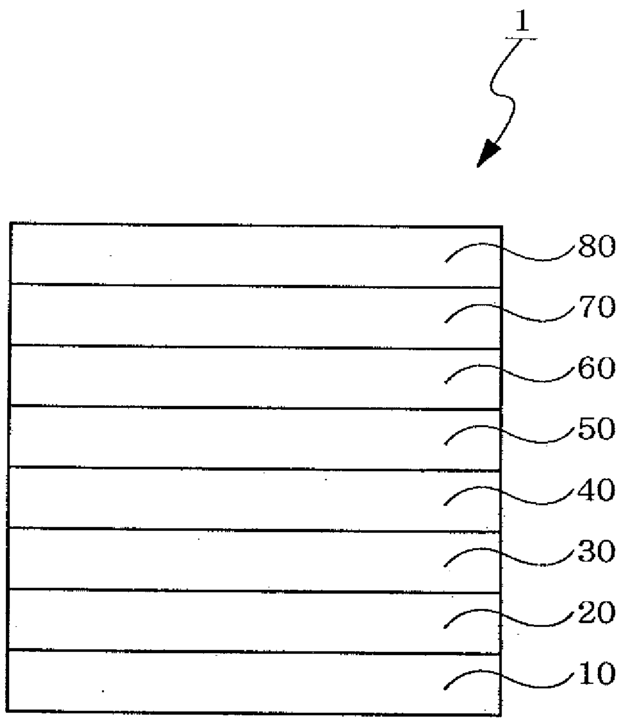

## INTERNATIONAL SEARCH REPORT

International application No.
PCT/JP2006/323463

A. CLASSIFICATION OF SUBJECT MATTER
*H01L51/50*(2006.01)i, *C09K11/06*(2006.01)i

According to International Patent Classification (IPC) or to both national classification and IPC

B. FIELDS SEARCHED

Minimum documentation searched (classification system followed by classification symbols)
H01L51/50, C09K11/06

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2007 |
| Kokai Jitsuyo Shinan Koho | 1971-2007 | Toroku Jitsuyo Shinan Koho | 1994-2007 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2003-338377 A (TDK Corp.), 28 November, 2003 (28.11.03), Claims; Par. Nos. [0034] to [0035], [0086] to [0188], [0427] to [0461], [0518] to [0534] (Family: none) | 1-10 |
| Y | JP 2005-276756 A (Seiko Epson Corp.), 06 October, 2005 (06.10.05), Par. Nos. [0040] to [0042] & US 2005-0255393 A1 | 1-15 |
| Y | JP 08-245954 A (Ricoh Co., Ltd.), 24 September, 1996 (24.09.96), Par. No. [0038] (Family: none) | 1-10 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 07 February, 2007 (07.02.07) | 20 February, 2007 (20.02.07) |
| Name and mailing address of the ISA/ Japanese Patent Office | Authorized officer |
| Facsimile No. | Telephone No. |

Form PCT/ISA/210 (second sheet) (April 2005)

**INTERNATIONAL SEARCH REPORT**

International application No.
PCT/JP2006/323463

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2003-229275 A (Semiconductor Energy Laboratory Co., Ltd.), 15 August, 2003 (15.08.03), Par. No. [0010] & JP 2005-101002 A & US 2003-0146443 A1 & US 2004-0124425 A1 | 1-10 |
| Y | JP 08-306487 A (Matsushita Electric Industrial Co., Ltd.), 22 November, 1996 (22.11.96), Par. Nos. [0006] to [0007] (Family: none) | 1-10 |
| Y | WO 2004-080975 A1 (Idemitsu Kosan Co., Ltd.), 23 September, 2004 (23.09.04), Claims; pages 17 to 36, line 44; page 47, lines 26 to 50 & EP 001602648 A1 & US 2006-147747 A | 11-15 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2001307885 A
- JP 2003338377 A
- JP 2005235564 A
- JP 57051781 A
- US 3112197 A
- US 3189447 A
- JP 3716096 B
- US 3615402 A
- US 3820989 A
- US 3542544 A
- JP 45555 B
- JP 51010983 B
- JP 51093224 A
- JP 55017105 A
- JP 56004148 A
- JP 55108667 A
- JP 55156953 A
- JP 56036656 A
- US 3180729 A
- US 4278746 A
- JP 55088064 A
- JP 55088065 A
- JP 49105537 A
- JP 55051086 A
- JP 56080051 A
- JP 56088141 A
- JP 57045545 A
- JP 54112637 A
- JP 55074546 A
- US 3615404 A
- JP 51010105 B
- JP 46003712 B
- JP 47025336 B
- JP 54053435 A
- JP 54110536 A
- JP 54119925 A
- US 3567450 A
- US 3180703 A
- US 3240597 A
- US 3658520 A
- US 4232103 A
- US 4175961 A
- US 4012376 A
- JP 49035702 B
- JP 3927577 B
- JP 55144250 A
- JP 56119132 A
- JP 56022437 A
- DE 1110518
- US 3526501 A
- US 3257203 A
- JP 56046234 A
- JP 54110837 A
- US 3717462 A
- JP 54059143 A
- JP 55052063 A
- JP 55052064 A
- JP 55046760 A
- JP 55085495 A
- JP 57011350 A
- JP 57148749 A
- JP 2311591 A
- JP 61210363 A
- JP 61228451 A
- JP 61014642 A
- JP 61072255 A
- JP 62047646 A
- JP 62036674 A
- JP 62010652 A
- JP 62030255 A
- JP 60093455 A
- JP 60094462 A
- JP 60174749 A
- JP 60175052 A
- US 4950950 A
- JP 2204996 A
- JP 2282263 A
- JP 1211399 A
- JP 632956965 A
- US 4127412 A
- JP 53027033 A
- JP 54058445 A
- JP 54149634 A
- JP 54064299 A
- JP 55079450 A
- JP 61295558 A
- JP 61098353 A
- JP 63295695 A
- US 5061569 A
- JP 4308688 A
- JP 8193191 A

**Non-patent literature cited in the description**


- **C. W. TANG ; C. W. TANG ; S. A. VANSLYKE et al.** of Eastman Kodak Co. reported a low-voltage driven organic EL device in the form of a stacked type device. *Applied Physics Letters,* 1987, vol. 51, 913